# EUROPEAN PATENT APPLICATION

(11) **EP 1 388 889 A2**
(43) Date of publication of application: **11.02.2004**
(21) Application number: 03368077.8
(22) Date of filing: 04.08.2003
(51) Int. Cl.: H01L 21/28

(54) **Method to form a gate insulator layer comprised with multiple dielectric constants and multiple thicknesses**

(30) Priority: 07.08.2002 US 213585
(71) Applicant: Chartered Semiconductor Manufacturing Pte Ltd., Singapore 738406 (SG)
(72) Inventor: Chew Hoe Ang, Singapore 680559 (SG); Liang Choo Hsia, Singapore 735406 (SG); Jia Zhen Zheng, Singapore 688570 (SG); Soh Yun Siah, Singapore 680234 (SG); Chooi, Simon, Singapore 118719 (SG)
(74) Representative: Schuffenecker, Thierry

(57) **Abstract**

A method of forming a dielectric layer on a semiconductor substrate, comprised with multiple dielectric constants and multiple equivalent oxide thicknesses (EOT), has been developed. After formation of a high dielectric constant (high k), layer, on a semiconductor substrate, a first region of the high k layer is subjected to a process directed at incorporating elements into a top portion of the high k layer, while a second region of the high k layer remains protected during this procedure. An anneal treatment results in the processed high k layer now exhibiting a different dielectric constant, as well as a different EOT, than the unprocessed, second region of the high k layer, not exposed to the above procedures.

## Description

### Technical field

The present invention relates to methods used to fabricate semiconductor devices, and more specifically to a method used to form a gate insulator layer comprised with multiple dielectric constants, and with multiple thicknesses, on the same semiconductor chip.

### Background art

Micro-miniaturization, or the ability to fabricate semiconductor devices with sub-micron features, has allowed device integration to progress to where an entire system on chip (SoC), can now be realized. The concept of SoC however requires multiple gate insulator layer thicknesses, as well as gate insulator layers offering multiple dielectric constants, to satisfy specific functions of the SoC design. The attainment of different gate insulator thicknesses on specific regions of a semiconductor substrate has been achieved via implantation into the semiconductor substrate prior to the thermal oxidation procedure used for growth of a silicon dioxide gate insulator layer, with the implanted species either enhancing or reducing the oxidation rate of the semiconductor substrate thus allowing various silicon dioxide gate insulator thicknesses to be obtained.

Implantation of such ions as fluorine, argon, and nitrogen, have been used to adjust the differential oxidation rates. However for enhanced device performance the thickness of gate insulator layers are being scaled down to thicknesses below 20 Angstroms, making the procedure of implantation into semiconductor prior to oxidation difficult to implement.

This invention will describe procedures in which specific regions of a gate insulator layer are formed with a specific dielectric constant and a specific thickness, while other regions of the same gate insulator layer are formed with a different dielectric constant and at a different thickness, accomplished via incorporation of various elements into specific regions of a gate insulator layer. Prior art such as Gilmer, in U.S. Pat. No. 6,348,386 B1, Ma et al, in U.S. Pat. No. 6,297,539 B1, Ma et al, in U.S. Pat. No. 6,207,589 B1, and Kaushik et al, in U.S. Pat. No. 6,184,072 B1, describe methods of forming metal oxide gate insulator layers. None of the above prior arts however describe the novel procedures illustrated in this present invention wherein incorporation of specific elements into specific regions of a gate insulator layer allow a different dielectric constant and different equivalent oxide thickness (EOT), than that of the non- processed regions of gate insulator, to be realized.

### Summary of the invention

It is an object of this invention to form a gate insulators layer on a semiconductor substrate, comprised with various dielectric constants and various equivalent oxide thicknesses.

It is another object of this invention to initially form a high dielectric constant (high k), layer on a semiconductor substrate, followed by placement of elements into specific regions of the high k layer to change the dielectric constant and to change the EOT of the region of high k layer exposed to this procedure.

It is still another object of the invention where a first embodiment places a first type of element into a high k layer to decrease the dielectric constant while increasing the EOT of the high k layer, while a second embodiment of the invention places a second type of element into a high k layer to increase the dielectric constant while decreasing the EOT of the processed high k layer.

In accordance with the present invention a method of forming a gate insulator layer comprised with various dielectric constants, and various equivalent oxide thicknesses (EOT), on the same semiconductor substrate, via incorporation of elements into a high k, gate insulator layer, to change the dielectric constant as well as the equivalent oxide thickness (EOT), of the gate insulator layer, is described. A first embodiment of this invention features the formation of a first high k dielectric layer on a semiconductor substrate followed by immersion or implantation of first type elements into a region of the first high k dielectric layer not covered by a block - out shape. An anneal procedure results in the first portion of the first high k layer, the portion exposed to the immersion of implantation procedure, now comprised with a lower dielectric constant, and an increased EOT, when compared to a second portion of the first high k layer not exposed to the immersion or implantation procedure. A second embodiment of this invention features the formation of a second high k dielectric layer on a semiconductor substrate followed by immersion or implantation of second type elements into a region of the second high k dielectric layer not covered by a block -out shape. An anneal procedure results in a first portion of the second high k layer, the region exposed to the immersion of implantation procedure, now comprised with a higher dielectric constant, and a decreased EOT, when compared to a second portion of the second high k layer not exposed to the immersion or implantation procedure.

Formation of gate structures on underlying gate insulator layers, comprised with various EOT and various dielectric constants, is then performed.

### Description of the drawings

The object and other advantages of this invention are best described in the preferred embodiment with reference to the attached drawings that include:

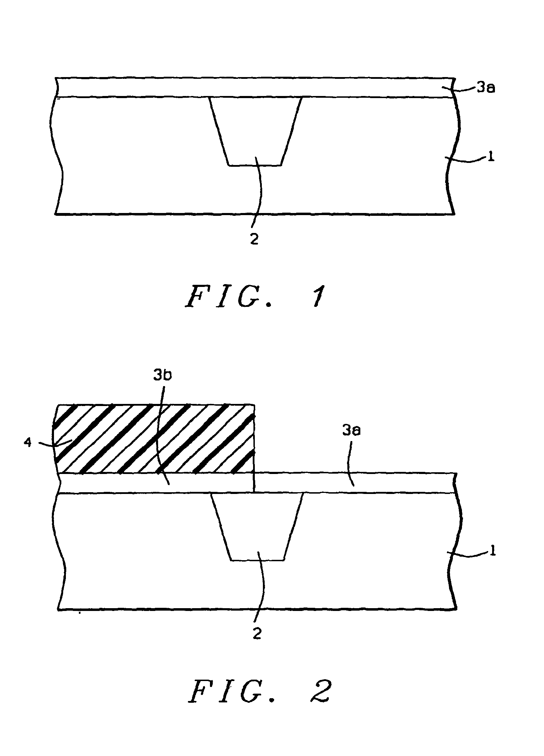

Figs. 1 - 3, which schematically, in cross-sectional style, describe a first embodiment of this invention in which immersion or implantation of a first group of elements into a first region of a first high k gate insulator layer, results in the exposed gate insulator region now comprised with a lower dielectric constant and a thicker equivalent oxide thicknesses (EOT), than a second region of the first high k layer not exposed to the immersion or implantation procedure.

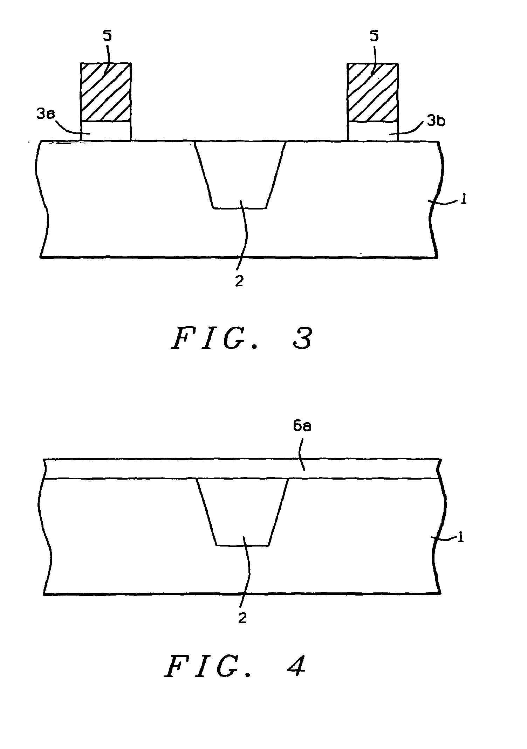

Figs. 4 - 6, which schematically, in cross-sectional style, describe a second embodiment of this invention in which immersion or implantation of a second group of elements into a first region of a second high k gate insulator layer, results in the exposed gate insulator region now comprised with a higher dielectric constant and a thinner equivalent oxide thickness (EOT), when compared to the second region of the second high k layer not exposed to the immersion or implantation procedure.

### Description of the preferred embodiments

The method of forming a gate insulator layer on a semiconductor substrate, wherein a first region of the gate insulator layer features a dielectric constant and a equivalent oxide thickness (EOT), different the dielectric constant and EOT of a second region of the gate insulator layer, will now be described in detail. Semiconductor substrate 1, comprised of single crystalline material featuring a <100> crystallographic orientation, is used and schematically shown in Fig. 1. Shallow trench isolation (STI) region 2, comprised of an insulator filled shallow trench shape, is next formed via definition of a shallow trench shape in a top portion of semiconductor substrate 1, followed by insulator filling of the shallow trench shape and removal of unwanted regions of insulator layer from the top surface of semiconductor substrate 1. The shallow trench shape can be defined via photolithographic and dry etching procedures, using Cl₂ as an etchant for silicon, while the insulator layer used for filling of the shallow trench shape can be a silicon oxide layer obtained via low pressure chemical vapor deposition (LPCVD), or via plasma enhanced chemical vapor deposition (PECVD), procedures. Removal of unwanted portions of insulator is either accomplished via a chemical mechanical polishing (CMP) procedure, or via a selective dry etching procedure using CHF₃ as an etchant for the insulator layer.

Dielectric layer 3a, comprised of either hafnium oxide (HfO₂), zirconium oxide (ZrO₂), or cerium oxide (CeO₂), is next grown on semiconductor substrate 1, to a physical thickness between about 40 to 80 Angstroms, featuring a high dielectric constant (high k), between about 20 to 28. The equivalent oxide thickness (EOT), of dielectric layer 3a, is between about 7 to 13 Angstroms.

Dielectric layer 3a, schematically shown in Fig. 1, is obtained via atomic layer deposition (ALD), or metal organic chemical vapor deposition (MOCVD), procedures, performed at a temperature between about 200 to 500° C. A first embodiment of this invention allowing a first region of the gate insulator layer to be formed on a first portion of the semiconductor substrate, featuring a specific dielectric constant and a specific insulator thickness, while a second region of the gate insulator layer, located on a second portion of the same semiconductor substrate, is processed to exhibit a lower dielectric constant and thicker insulator layer than the first region of the gate
insulator layer, is next described. Photoresist shape 4, is formed on a first region of dielectric layer 3a, allowing the exposed portion of dielectric layer 3a, to experience immersion or implantation of specific elements, such as silicon, germanium, or aluminum. Incorporation of an element such as silicon into a HfO₂ dielectric layer is accomplished via either plasma immersion procedures, performed at a power between about 50 to 1000 watts, at a pressure between about 10 to 500 mtorr, or performed via implantation of the specific element such as silicon, at an implant energy between about 0.1 to 1.0 KeV, and at an implant dose between about 1E13 to 1E15 atoms/cm², resulting in the creation of dielectric layer 3b. This is schematically shown in Fig. 2.

After removal of photoresist shape 4, via plasma oxygen ashing procedures, an anneal procedure is used to activate the incorporated ions in dielectric layer 3b, resulting in a dielectric layer 3b, such as HfSiₓO_{y}, featuring a dielectric constant between about 8 to 16, lower than the dielectric constant of non - treated dielectric layer 3a. In addition although the physical thickness of dielectric layer 3b, remains between about 40 to 80 Angstroms, the change in dielectric constant results in an EOT for dielectric layer 3b, of between about 13 to 27 Angstroms.

Therefore the desired result of providing multiple thicknesses within a gate insulator layer, on the same semiconductor substrate, is accomplished. The anneal procedure, which can be an optional step since the immersed or implanted species can provide a portion of the changes in dielectric constant and EOT without annealing, is performed at a temperature between about 400 to 700° C, in an inert, or in an oxidizing ambient. A conductive layer such as doped polysilicon, titanium nitride, tantalum nitride, or molybdenum is next formed on the underlying dielectric layers, at a thickness between about 1000 to 2000 Angstroms, via chemical vapor deposition (CVD), or via plasma vapor deposition (PVD), procedures. A photoresist shape, not shown in the drawings, is then employed as a mask to allow an anisotropic reactive ion etching (RIE) procedure, using Cl₂ or SF₆ as an etchant, to define conductive gate structures 5, on thinner EOT, underlying dielectric or gate insulator layer 3a, and on thicker EOT, underlying dielectric or gate insulator layer 3b. This is schematically shown in Fig. 3.

A second embodiment of this invention directed at obtaining a first region of a gate insulator layer on a semiconductor substrate, featuring a specific dielectric constant and a specific insulator thickness, while a second region of the same gate insulator layer located on the same semiconductor substrate, is formed with a higher dielectric constant and thinner equivalent oxide thickness than the first region of the gate insulator layer, is next described. Dielectric layer 6a, comprised of aluminum oxide (Al₂O₃), is formed on semiconductor substrate 1, with a physical thickness between about 80 to 100 Angstroms, and with a dielectric constant between about 10 to 14, translating to a EOT between about 27 to 33 Angstroms. Aluminum oxide, dielectric layer 6a, is obtained via CVD procedures. This is schematically shown in Fig. 4.

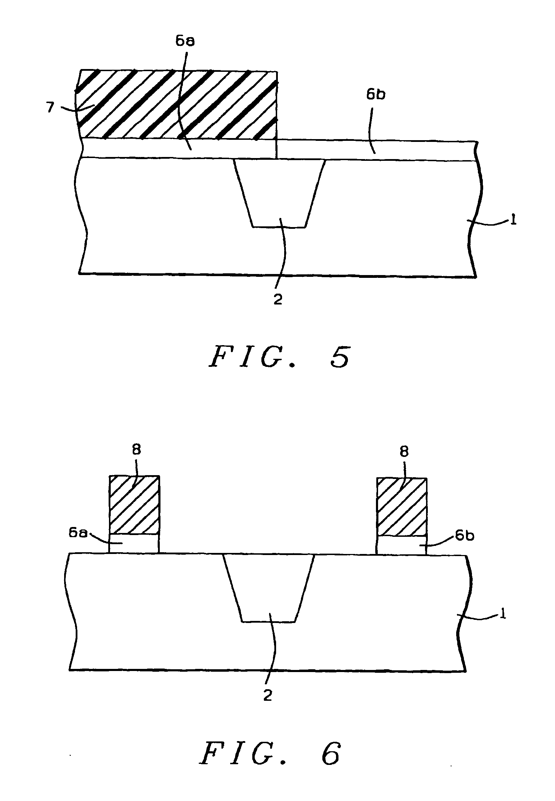

Photoresist shape 7, is next formed on a first region of dielectric layer 6a, allowing the exposed portion of dielectric layer 6a, to experience immersion or implantation of specific elements, such as hafnium, zirconium, or silicon. Incorporation of an element such as hafnium into the Al₂O₃ layer is accomplished via either plasma immersion procedures, performed at a power between about 50 to 1000 watts, at a pressure between about 10 to 50 mtorr, or performed via implantation of the specific element such as hafnium, at an implant energy between about 0.1 to 1.0 KeV, and at an implant dose between about 1E13 to 1E15 atoms/cm², resulting n the creation of dielectric layer 6b. This is schematically shown in Fig. 5.

After removal of photoresist shape 7, via plasma oxygen ashing procedures, an optional anneal procedure can be used to activate the incorporated hafnium element in the Al₂O₃ layer resulting in an HfAlₓO_{y} dielectric layer 6b. Dielectric layer 6b, HfAlₓO_{y}, features a dielectric constant between about 12 to 20, higher than the dielectric constant of non - treated dielectric layer 6a. In addition, although the physical thickness of dielectric layer remains between about 80 to 100 Angstroms, the change in dielectric constant results in an EOT for dielectric layer 6b, of between about 20 to 25 Angstroms, less than the EOT of non -treated Al₂O₃ counterparts. Therefore the desired result of providing multiple thicknesses for specific regions of a gate insulator layer, is again accomplished. The anneal procedure, which again can be an optional step since the immersed or implanted species can provide a portion of the desired changes in dielectric constant and EOT without annealing, is performed at a temperature between about 400 to 700° C, in an inert, or in an oxidizing ambient. A conductive layer such as doped polysilicon, titanium nitride, tantalum nitride, or molybdenum is next formed on the underlying dielectric layers, at a thickness between about 1000 to 2000 Angstroms, via chemical vapor deposition (CVD), or via plasma vapor deposition (PVD), procedures. A photoresist shape, not shown in the drawings, is then employed as a mask to allow an anisotropic reactive ion etching (RIE) procedure, using Cl₂ or SF₆ as an etchant, to define conductive gate structures 5, on thicker EOT, underlying dielectric or gate insulator layer 6a, and on thinner EOT, underlying dielectric or gate insulator layer 6b. This is schematically shown in Fig. 6.

## Claims

1. A method of forming a dielectric layer on a semiconductor substrate featuring multiple equivalent oxide thicknesses, comprising the steps of:
- forming a first dielectric layer comprised with a physical thickness, a first dielectric constant, and a first equivalent oxide thickness (EOT);
- incorporating an element into a second region of said first dielectric layer, forming a second dielectric layer, while a first region of said first dielectric layer remains untreated;
- performing an anneal procedure resulting in said second dielectric layer now comprised a second dielectric constant and with a second EOT; and
- forming conductive gate structures on said first dielectric layer and on said second dielectric layer.

2. The method of claim 1, wherein said first dielectric layer is comprised of hafnium oxide, zirconium oxide, cerium oxide.

3. The method of claim 1, wherein said first dielectric layer is formed with a physical thickness between about 40 to 80 Angstroms.

4. The method of claim 1, wherein the dielectric constant of said first dielectric layer is between about 20 to 28.

5. The method of claim 1, wherein said equivalent oxide thickness (EOT), of said first dielectric layer is between about 7 to 13 Angstroms.

6. The method of claim 1, wherein said element incorporated into said second region of said first dielectric layer is silicon, germanium, or aluminum.

7. The method of claim 1, wherein said second dielectric layer is comprised with a physical thickness between about 40 to 80 Angstroms.

8. The method of claim 1, wherein the dielectric constant of said second dielectric layer is between about 8 to 16.

9. The method of claim 1, wherein said equivalent oxide thickness (EOT), of said second dielectric layer is between about 13 to 27 Angstroms.

10. A method of forming a dielectric layer with multiple equivalent oxide thicknesses, on a semiconductor substrate, comprising the steps of:
- forming a first dielectric layer comprised with a physical thickness, a first dielectric constant, and a first equivalent oxide thickness (EOT);
- incorporating an element into a second region of said first dielectric layer forming a second dielectric layer while a first region of said first dielectric layer remains untreated, with a dielectric constant for said second dielectric layer larger than the dielectric constant of said first dielectric layer, and with an EOT for second dielectric layer smaller than the EOT for said first dielectric layer;
- performing an anneal procedure; and
- forming conductive gate structures on said first dielectric layer and on said second dielectric layer.

11. The method of claim 10, wherein said first dielectric layer is comprised of aluminum oxide, at a physical thickness between about 80 to 100 Angstroms.

12. The method of claim 10, wherein the dielectric constant of said first dielectric layer is between about 10 to 14.

13. The method of claim 10, wherein said equivalent oxide thickness (EOT), of said first dielectric layer is between about 27 to 33 Angstroms.

14. The method of claim 10, wherein said element incorporated into said second region of said first dielectric layer is hafnium, zirconium, or silicon..

15. The method of claim 1 or 10, wherein said element is incorporated in said second region of said first dielectric layer via a plasma immersion procedure performed at a power between about 50 to 1000 watts, at a pressure between about 10 to 500 mtorr.

16. The method of claim 1 or 10, wherein said element is incorporated in said second region of said first dielectric layer via an ion implantation procedure, performed at an energy between about 0.1 to 1.0 KeV, and at a dose between about 1E13 to 1E15 atoms/cm².

17. The method of claim 1 or 10, wherein said anneal procedure is performed at a temperature between about 400 to 700° C, in an inert or in an oxidizing ambient.

18. The method of claim 1 or 10, wherein said second dielectric layer is comprised of HfAlₓO_{y.}

19. The method of claim 10, wherein said second dielectric layer is comprised with a physical thickness between about 80 to 100 Angstroms.

20. The method of claim 10, wherein the dielectric constant of said second dielectric layer is between about 12 to 20.

21. The method of claim 10, wherein said equivalent oxide thickness (EOT), of said second dielectric layer is between about 20 to 25 Angstroms.

22. The method of claim 1 or 10 , wherein said conductive gate structures are comprised of doped polysilicon, titanium nitride, tantalum nitride, or molybdenum.
